# EUROPEAN PATENT APPLICATION

(11) **EP 4 290 585 A1**
(43) Date of publication of application: **13.12.2023**
(21) Application number: 22177802.0
(22) Date of filing: 08.06.2022
(51) Int. Cl.: H01L 29/78, H01L 21/336, H01L 29/10

(54) **LATERAL ORIENTED METAL-OXIDE-SEMICONDUCTOR, MOS DEVICE COMPRISING A SEMICONDUCTOR BODY**

(71) Applicant: Nexperia B.V., 6534 AB Nijmegen (NL)
(72) Inventor: Kumar, Manoj, 560 055 Bangalore (IN); Ong, Kilian, 6534AB Nijmegen (NL)
(74) Representative: Pjanovic, Ilija

(57) **Abstract**

A lateral oriented Metal-Oxide-Semiconductor, MOS device comprising a semiconductor body having a first surface, the semiconductor body comprising a first region having a first conductivity type; a trench extending from said first surface into said first region, said trench comprising an insulating element and a conductive element wherein said insulating element is arranged in between said conductive element and said first region, wherein said insulating element has a substantially uniform width; second and third regions having a second conductivity type, said second conductivity being different from said first conductivity type, wherein said second and third regions extend from said first surface into said first region and are located on either side of said trench and adjacent to said trench, and are not in contact with one another; and a further insulating region on said first surface comprising openings for providing electrical contact to said second and third regions. A corresponding method of manufacturing such a device is also disclosed herein.

## Description

### Technical field

The present disclosure relates to the field of semiconductors and, more specifically, to the field of lateral Metal-Oxide-Semiconductor Field Effect Transistors, MOSFETs and a method of manufacturing such devices..

### Background

The present disclosure generally relates to power Metal Oxide Semiconductor Field Effect Transistors, MOSFETs, and more particularly to such device used in synchronous rectifier circuit applications and exhibiting low on-resistance, fast switching speed, high voltage capability, and bidirectionality in AC circuits.

Power MOSFET devices have a number of advantageous characteristics including high gate impedance, low on-resistance for low forward voltage drop, high withstand voltage capability, and fast switching speeds. Properly gated, they can be employed in synchronous rectifier circuits which previously employed devices such as conventional PN junction rectifiers, Schottky rectifiers or bipolar transistor synchronous rectifiers.

Employing a trench gate is known especially in vertically oriented MOSFET devices, however the use of a trench-gate in lateral devices has not been substantially explored. It is understood that by using the term "lateral devices" the present disclosure relates to a field of devices wherein the channel that is formed during a conduction state of the MOSFET device is substantially lateral, and not vertical.

A known prior art document WO 2001082359 A2 discloses the trench-gate, but with a lower insulating layer in a lower part of the trench and with a thicker upper insulating layer in an upper part of the trench. Furthermore, the method used for obtaining such a device comprises a large number of steps involving several sacrificial materials and hence is complex.

Thus there is a need to implement a simpler process for manufacturing trench gate MOSFET devices.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

It is an object of the present disclosure to provide for a lateral oriented semiconductor device with a smaller pitch. It is a further object of the present disclosure to provide for a corresponding method.

The inventors have found that the pitch can be made much more compact by utilizing a trench and providing an insulated gate electrode in this trench.

In a first aspect of the present application, there is presented a lateral oriented Metal-Oxide-Semiconductor, MOS device comprising a semiconductor body having a first surface, the semiconductor body comprising a first region having a first conductivity type; a trench extending from said first surface into said first region, said trench comprising an insulating element and a conductive element wherein said insulating element is arranged in between said conductive element and said first region, wherein said insulating element has a substantially uniform width; second and third regions having a second conductivity type, said second conductivity being different from said first conductivity type, wherein said second and third regions extend from said first surface into said first region and are located on either side of said trench and adjacent to said trench, and are not in contact with one another; and a further insulating region on said first surface comprising openings for providing electrical contact to said second and third regions.

By providing the gate within a trench, the pitch of the lateral device can be reduced. The skilled person understands that in normal lateral MOS devices, the gate terminal is also located on top of the device, thereby presenting an increased pitch. However, by employing a trench and disposing the gate in the trench, the space top of the device can be utilised in a more efficient manner, thereby reducing the pitch of the device.

Furthermore, by ensuring that the insulating element has a substantially uniform width, there are no complex steps involved during the manufacture process of such a device. The insulating element of substantially uniform thickness is provided in one step after the trench is performed. The skilled person understands that the insulating element, preferably, has a uniform thickness. Consequently, the manufacture process is fairly simple when compared to the known techniques that employ filler materials and several intermediate steps to achieve a trench-gate.

The first conductivity type may either be p-type or an n-type. The second conductivity type may then be either an n-type or a p-type. The skilled person understands that the first and the second conductivity types are not the same. The selection of the conductivity types is based on the desired channel type of the semiconductor device. As an example, if an n-channel MOSFET device is desired, the first conductivity type of p-type and the second conductivity type is of n-type.

The second and third regions may form the source and drain of the MOSFET device, with the gate being located within the trench. The skilled person understands that the terminal for the trenched gate terminal may be provided suitably on another surface, that is not the top of the device.

It was the insight of the inventors, that the trench process could be directly performed on the first region, without the need for providing a filler material or other sacrificial materials.

According to an example, the first region is a moderately doped substrate. In this case, there is no need for growing a first EPI layer on which the device is usually formed. The trench is formed directly in the substrate, However, it is required that the substrate be moderately doped. The skilled person understands that the term moderately doped refers to a doping concentration of about 1 impurity per 10^6 - 10^8 atoms.

According to an example, said first region is an EPI layer arranged over a substrate. In practice, this embodiment is more common and follows the more common approach of manufacturing a semiconductor device. In such devices, the first region is often a EPI layer that has been grown over a suitable substrate. The substrate itself may or may not be doped. But the region in which the trench is formed, i.e. the first region, which in this exemplary embodiment is an EPI layer, is moderately doped. The skilled person understands the term moderately doped refers to a doping concentration of about 1 impurity per 10^6 - 10^8 atoms.

According to an example, the device comprises a further electrical contact arranged to provide electrical contact to said conductive element in said trench, wherein said further electrical contact is located on a plane perpendicular to said first surface. Such an electrical contact is arranged to provide electrical signal to the gate electrode that forms the conductive element in the trench.

According to an example, the device further comprises a lightly doped implanted channel of said first conductivity type located in said first region, wherein said implanted channel connects said second and third regions respectively. As an example, the inventors considered a p-type MOSFET and found that they were able to achieve a better enhancement by implementing a lightly doped implanted channel. The skilled person understands that the term lightly doped refers to a concentration of about 1 impurity per 10^11 atoms.

According to an example, the second and third regions are heavily doped. The skilled person understands that the term heavily doped refers to a concentration of about 1 impurity per 10^3 atoms. These second and third regions form, for example, a source and drain respectively of the MOSFET.

In an exemplary embodiment, the further insulating region is arranged to insulate said conductive element along said first surface. In such a manner, it can be ensured that the conductive elements that forms the gate electrode does not accidentally come in contact with anu other elements of the transistor.

The semiconductor device according to any of the previous claims wherein said second and third regions form the source and drain terminals of a MOS Field Effect Transistor, MOSFET, device, and wherein said conductive element forms said gate terminal of said MOSFET device.

According to an example, said conductive element is of metal or of poly-silicon. Poly-silicon or Poly-crystalline silicon is a commonly used alternative that is used in place of metallic electrode. This has an advantage in the manufacture process of the device.

According to an example, the insulating element and said further insulating regions are of silicon dioxide.

In a second aspect of the present disclosure, there is presented a method of manufacturing a lateral oriented Metal-Oxide-Semiconductor, MOS device according to any of the examples of the first aspect, wherein the device has a first surface, and wherein the method comprises the steps of:
- providing a first region having a first conductivity type;
- etching a trench extending from said first surface into said first region;
- providing an insulating element of substantially uniform width in said trench;
- providing a conductive element in said trench;
- providing second and third regions having a second conductivity type, said second conductivity being different from said first conductivity type, wherein said second and third regions extend from said first surface into said first region and are located on either side of said trench and adjacent to said trench, and are not in contact with one another;
- providing a further insulating region on said first surface comprising openings for providing electrical contact to said second and third regions.

It is noted that the advantages as explained with reference to the first aspect of the present disclosure, being the vertical semiconductor device, are also applicable to the second aspect of the present disclosure, being the method of manufacturing a vertical oriented semiconductor device.

According to an example of the second aspect, said first region is provided on top of a suitable substrate.

According to a further example of the second aspect, the method further comprises a step of providing suitable metallic contacts for the electrodes by means of a metallization process flow.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Figures 1 - 6 show the different stages of a manufacturing a device according to the present disclosure.
Fig. 7 illustrates a semiconductor device according to the present disclosure.

### Detailed Description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

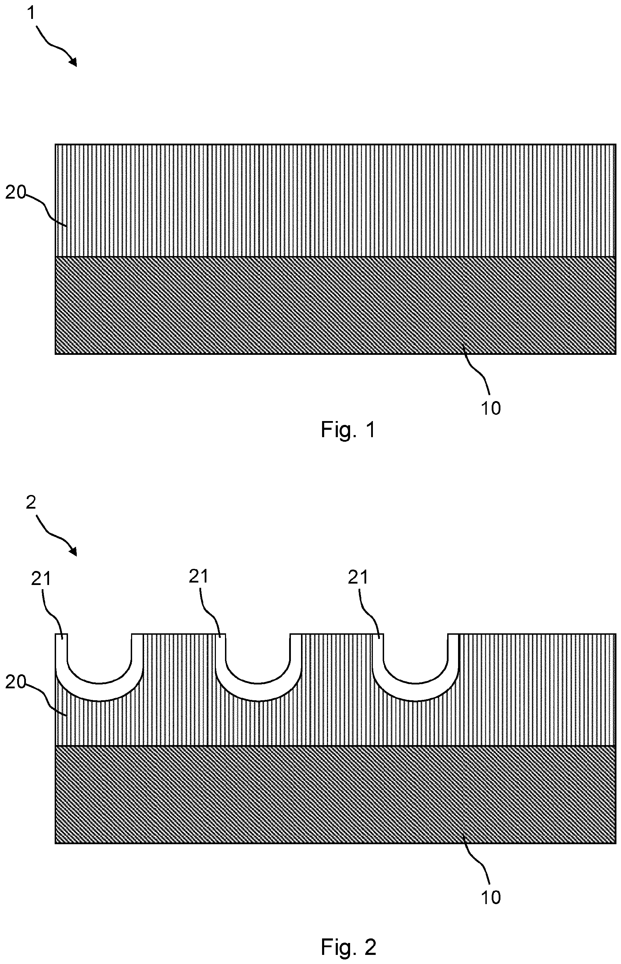

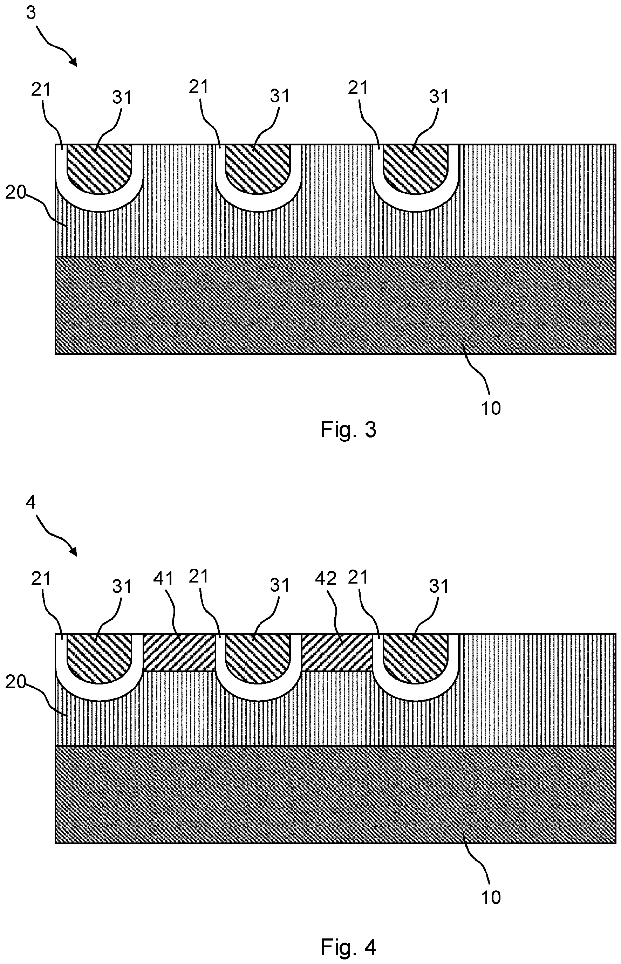

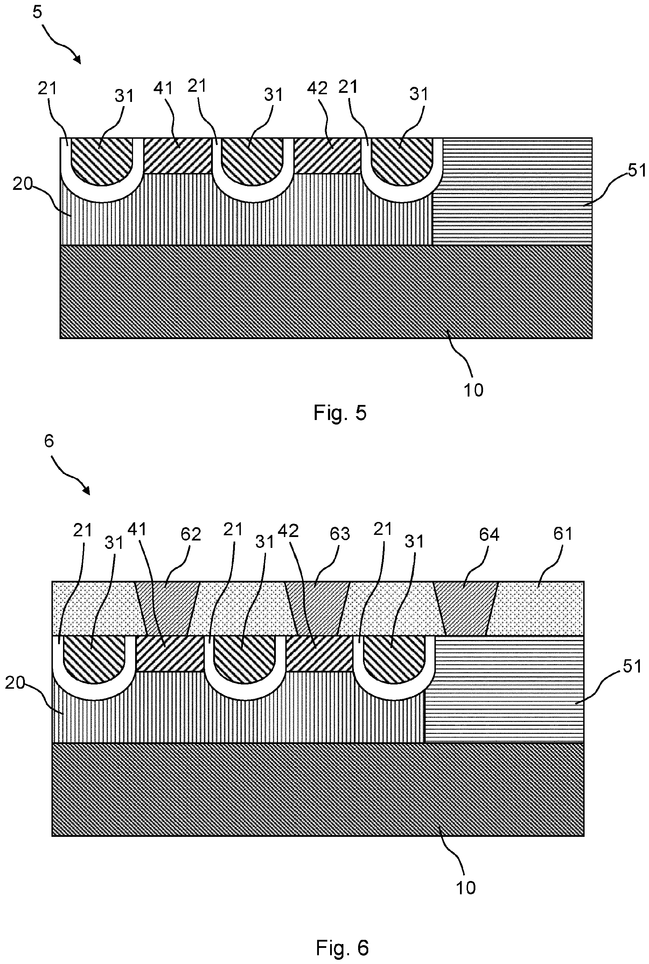

Figures 1 - 6 show the different stages of a manufacturing a device according to the present disclosure. The present disclosure will now be elaborated with reference to these figures.

Reference number 1 indicates the first step in the process, where a P/N EPI layer 20 is grown on a suitable substrate 10. The P/N EPI layer 20 then defines the first region in the sense of the present disclosure. However, it is noted, that the first region may also be formed by the substrate 10 without the need for the P/N EPI layer. In such a case, the substrate 10 should also be moderately doped.

If the substrate 10 and the P/N EPI layer 20 are both used, they both should have the same conductivity type. The only difference would be then in the doping concentration. The substrate 10 should be heavily doped and the EPI layer 20 is moderately doped.

In a subsequent step 2, a trench is made which is insulated by an insulating element 21. The trench is made by any known process including chemical etching or by subjecting the surface to irradiation by a suitable source. The insulating element 21 is then grown in/deposited into the trench. Such a process ensures that the insulating element 21 has a substantially uniform width. Preferably, the insulating element 21 has the same width. This makes the manufacturing process very efficient.

Once a trench is formed and the insulating element 21 is deposited therein, the poly process is initiated in the next step 3 to form a conductive element 31 in the trench. The conductive element 31 may be formed in-situ or could be a doped Poly-Silicon element.

In step 4, a second 41 and third region 42 are formed on the first region 20 adjacent to the trenches. The second and third regions, 41, 42 form the source and drain of the device respectively. It should be noted that the second and third regions 41, 42 have a different conductivity type than the first region. For example, if the first region has a conductivity of P-type, then both the second and third regions have conductivity of n-type

The skilled persons also understands that the second and third regions 41, 42 that form the source and drain regions are to be heavily doped. Furthermore, the type of conductivity also depends on the channel type of the MOSFET that is to be manufactured. For example, for an N-type MOSFET, the second and third regions have a conductivity of n-type and the first region is of p-type.

In step 5, the bulk 51 of the device is also doped. The bulk of the device is doped so as to offer a body/bulk terminal for the MOSFET device.

Step 6 comprises the metallization overflow together with the insulation. The surface of the device is insulated using a further insulating region 61. Suitable opening are brought into the further insulating region, which are designed to accommodate electrodes that contact the respective regions. For example, electrode 62 forms the source electrode and is in contact with the second region 41. Electrode 63 forms the drain and is in contact with the third region 42, and electrode 64 forms the body/bulk electrode and is in contact with the body/bulk region 51.

Such a device offers a reduced pitch, has a lowers specific Drain-Source On resistance, R_{DS, ON}. Furthermore, the method according to the present disclosure as described above is simpler and faster than other known methods to manufacture similar lateral gated trench devices.

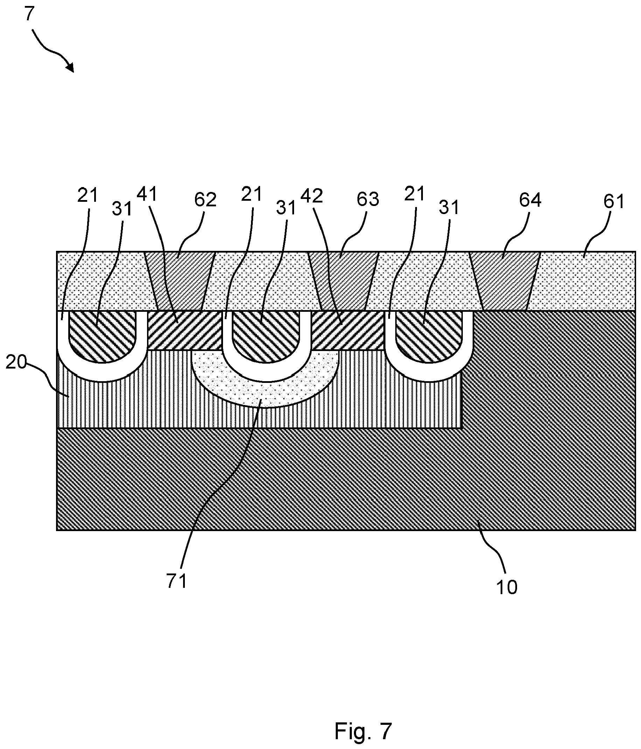

Fig. 7 schematically illustrates a special embodiment according to the present disclosure, which comprises an additional implanted channel 71. It was the insight of the inventors that when a p-type enhancement MOSFET was being used, the presence of such an channel 71 connecting the second and third regions 41, 42 improves the performance of the device. The implanted channel 71 should then be very lightly doped so as to avoid undesired turn on.

### LIST OF REFERENCE NUMERALS

- 1 - 7: Different stages of manufacturing a semiconductor device
- 10: Substrate
- 20: EPI
- 21: Insulating element
- 31: Conductive element
- 41: Second Region
- 42: Third region
- 51: Body
- 62: Electrode; Source
- 63: Electrode; Drain
- 64: Electrode; Body
- 71: Extension depth

## Claims

1. A lateral oriented Metal-Oxide-Semiconductor, MOS device comprising a semiconductor body having a first surface, the semiconductor body comprising:
- a first region having a first conductivity type;
- a trench extending from said first surface into said first region, said trench comprising an insulating element and a conductive element wherein said insulating element is arranged in between said conductive element and said first region, wherein said insulating element has a substantially uniform width;
- second and third regions having a second conductivity type, said second conductivity being different from said first conductivity type, wherein said second and third regions extend from said first surface into said first region and are located on either side of said trench and adjacent to said trench, and are not in contact with one another;
- a further insulating region on said first surface comprising openings for providing electrical contact to said second and third regions.

2. The semiconductor device according to claim 1, wherein said first region is a moderately doped substrate.

3. The semiconductor device according to claim 1, wherein said first region is an EPI layer arranged over a substrate.

4. The semiconductor device according to any of the previous claims comprising a further electrical contact arranged to provide electrical contact to said conductive element in said trench, wherein said further electrical contact is located on a plane perpendicular to said first surface.

5. The semiconductor device according to any of the previous claims further comprising a lightly doped implanted channel of said first conductivity type located in said first region, wherein said implanted channel connects said second and third regions respectively.

6. The semiconductor device according to any of the previous claims wherein said second and third regions are heavily doped.

7. The semiconductor device according to any of the previous claims, wherein said further insulating region is arranged to insulate said conductive element along said first surface.

8. The semiconductor device according to any of the previous claims wherein said second and third regions form the source and drain terminals of a MOS Field Effect Transistor, MOSFET, device, and wherein said conductive element forms said gate terminal of said MOSFET device.

9. The semiconductor device according to any of the previous claims wherein said conductive element is of metal or of poly-silicon.

10. The semiconductor device according to any of the previous claims wherein said insulating element and said further insulating regions are of silicon dioxide.

11. A method of manufacturing a lateral oriented Metal-Oxide-Semiconductor, MOS device according to any of the claims 1 - 10, wherein the device has a first surface, and wherein the method comprises the steps of:
- providing a first region having a first conductivity type;
- etching a trench extending from said first surface into said first region;
- providing an insulating element of substantially uniform width in said trench;
- providing a conductive element in said trench;
- providing second and third regions having a second conductivity type, said second conductivity being different from said first conductivity type, wherein said second and third regions extend from said first surface into said first region and are located on either side of said trench and adjacent to said trench, and are not in contact with one another;
- providing a further insulating region on said first surface comprising openings for providing electrical contact to said second and third regions.

12. The method according to claim 11, wherein said first region is provided on top of a suitable substrate.

13. The method according to any of claims 11 - 12, further comprising a step of providing suitable metallic contacts for the electrodes by means of a metallization process flow.
